# FASCICULE DE BREVET EUROPEEN

(11) **EP 0 470 899 B1**
(45) Date de publication et mention de la délivrance du brevet: **07.01.1998**
(21) Numéro de dépôt: 91402171.2
(22) Date de dépôt: 02.08.1991
(51) Int. Cl.: H01L 23/48, H01L 25/11

(54) **Diode à électrodes et à boîtier assemblés sans soudure ni sertissage et pont redresseur réalisé avec de telles diodes**
Diode mit Elektroden und Gehäuse zusammengesetzt ohne Lötmittel oder Fassung und Gleichrichterbrücke verwirklicht mit solchen Dioden
Diode having electrodes and housing assembled without soldering or crimping and rectifier bridge created with such diodes

(30) Priorité: 07.08.1990 FR 9010067
(43) Date de publication de la demande: 12.02.1992
(73) Titulaire: AUXILEC, F-78400 Chatou (FR)
(72) Inventeur: Boudrant, Antoine, F-92045 Paris la Défense (FR); Skorucak, Bela, F-92045 Paris la Défense (FR)
(74) Mandataire: Guérin, Michel

(56) Documents cités:
- EP-A- 0 022 359
- DE-A- 1 614 630
- DE-A- 3 524 191
- FR-A- 2 077 332
- GB-A- 2 157 487
- US-A- 4 224 663
- US-A- 4 305 087
- US-A- 4 670 678

## Description

La présente invention concerne une diode à électrodes et à boîtier assemblés sans soudure ni sertissage et un pont redresseur réalisé avec de telles diodes.

En dehors des batteries et des génératrices à courant continu à collecteur, le courant continu peut être également fourni par des alternateurs redresseurs ou par des transformateurs redresseurs à partir d'une source de courant alternatif. Ces alternateurs redresseurs et transformateurs redresseurs comportent un ou plusieurs ponts redresseurs qui convertissent le courant alternatif à l'entrée en courant continu ou redressé à la sortie. Un pont redresseur est constitué par un certain nombre de diodes dont le fonctionnement génère des pertes calorifiques qui exigent une efficace évacuation de la chaleur pour éviter toute élévation nuisible de température. Les diodes connues vendues dans le commerce sont généralement enfermées individuellement dans des boîtiers standards hermétiques qui les protègent contre toutes agressions extérieures d'origine mécanique, chimique électrique. Dans leur exploitation, ces diodes connues sont en général associées à des radiateurs en matériau bon conducteur de la chaleur fixés sur leurs boîtiers de protection afin d'augmenter leur surface d'échange thermique avec le milieu ambiant ou avec une convection de fluide de refroidissement et d'évacuer efficacement la chaleur engendrée par leurs pertes thermiques lors de leur fonctionnement. Aux volumes et masses des boîtiers de ces diodes connues s'ajoutent aussi le volume et la masse de leurs radiateurs de sorte qu'un pont redresseur réalisé avec ces diodes connues est relativement volumineux et pesant. Un tel pont redresseur se révèle peu recommandable pour certains équipements tels que par exemple les équipements aéronautiques où un encombrement réduit et une faible masse sont généralement exigés.

Par ailleurs pour assurer une meilleure fiabilité de fonctionnement, on choisit fréquemment pour constituer le pont redresseur, des diodes à surcapacité, c'est-à-dire des diodes qui fonctionnent non pas à leur courant nominal mais à une valeur inférieure à ce courant. De plus on associe généralement à ces diodes, des radiateurs correspondant à leur puissance nominale. Ces diodes surpuissantes avec leurs radiateurs associés sont normalement plus encombrantes et plus pesantes que les diodes à capacité normale munies de leurs radiateurs. Des ponts redresseurs réalisés avec ces diodes surpuissantes sont de ce fait relativement volumineux et pesants.

Les diodes connues sont en outre relativement onéreuses, étant donné que l'assemblage de leurs électrodes et boîtiers métalliques ou métallo-céramiques, par soudage et sertissage, fait souvent appel à des procédés complexes et des outillages généralement coûteux. Dans le brevet FR-A-2077 332 par exemple, les électrodes sont en contact avec l'élément semi-conducteur grâce à un organe élastique et le boîtier est fermé hermétiquement par un couvercle soudé.

La présente invention visant à éviter les inconvénients ci-dessus permet de réaliser une diode efficace en fonctionnement, économique en fabrication, faible en encombrement, faible en masse et pourvue d'électrodes et boîtier assemblés sans soudure ni sertissage.

Elle a également pour objet un pont redresseur économique, efficace, léger et peu encombrant réalisé avec de telles diodes.

L'invention propose une diode telle que précisée dans la revendication 1.

Un pont redresseur destiné à convertir un courant alternatif polyphasé en un courant continu ou redressé est caractérisé en ce qu'il est constitué par des sous-ensembles à plusieurs diodes et ayant chacun pour l'une des deux électrodes de ces diodes, une électrode commune qui sert également de boîtier et de radiateur, et pour l'autre des deux électrodes de ces diodes, des électrodes individuelles.

Pour mieux faire comprendre l'invention on en décrit ci-après un certain nombre d'exemples de réalisation illustrés par des dessins ci-annexés dont :
- la figure 1 représente une vue partielle schématique en coupe verticale d'une diode réalisée selon l'invention,
- la figure 2 représente une vue latérale schématique en coupe partielle d'une variante de réalisation sous forme d'un sous-ensemble à plusieurs diodes de la figure 1, et
- la figure 3 représente une vue de dessus schématique, partielle du sous-ensemble à plusieurs diodes de la figure 2.

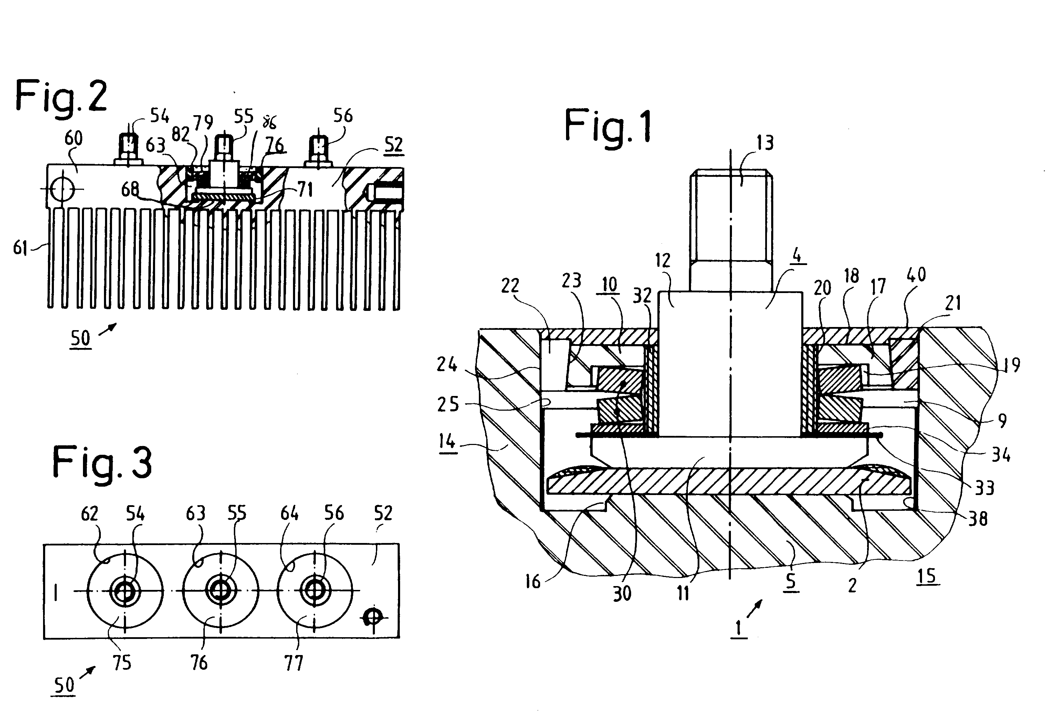

Une diode 1 illustrée dans la figure 1 comprend une pastille à passage unidirectionnel de courant électrique 2 d'un type connu et deux électrodes d'entrée et de sortie de courant électrique 4 et 5 respectivement assemblées aux deux faces opposées de cette pastille 2.

La pastille à passage unidirectionnel de courant électrique 2 qui constitue la diode proprement dite est disposée dans un creux 9 formé dans l'une 5 de ces deux électrodes 4 et 5 de la diode 1 de manière à faire accomplir par cette électrode 5 parallèlement trois fonctions : celle d'une électrode pour une entrée ou une sortie de courant électrique, celle d'un radiateur qui évacue la chaleur engendrée par des pertes thermiques de la diode 1 en fonctionnement, et celle d'un boîtier de protection de cette pastille à passage unidirectionnel de courant 2 contre toutes agressions extérieures d'origine mécanique, chimique, électrique.

Le creux 9 de l'électrode 5 est fermé par un couvercle 10. Dans la diode 1, les électrodes 4 et 5 et le couvercle 10 de boîtier sont respectivement assemblés sans soudure ni sertissage.

Les deux électrodes 4 et 5 sont maintenues assemblées aux deux faces opposées de la pastille à passage unidirectionnel de courant électrique 2 par simple contact intime de conduction électrique et thermique sous l'action permanente d'une pression exercée par un organe élastique tandis que le couvercle 10 est maintenu solidement en position de fermeture dans le creux de boîtier 9 par simple coincement sous une poussée continue exercée par cet organe élastique.

Dans la diode 1 de l'exemple de la figure 1, la pastille à passage undirectionnel de courant électrique 2 a une forme circulaire et comprend deux faces opposées destinées à recevoir respectivement les deux électrodes 4 et 5 dont l'une est une électrode d'entrée de courant électrique et l'autre est une électrode de sortie de courant électrique.

Dans la diode 1, l'électrode 4 a une forme d'une vis ayant une tête plate 11, un corps lisse 12 et un bout fileté 13. La tête plate 11 est appliquée en contact intime de conduction électrique et thermique contre une première des deux faces opposées de la pastille 2 et le bout fileté 13 est destiné à la fixation d'un fil ou câble électrique de connexion. L'électrode 5 servant également de boîtier et de radiateur de la diode 1, a une forme géométrique prédéterminée et comprend une partie massive dite boîtier électrode 14 et une partie radiateur 15 à structure massive ou taillée en ailettes. La partie boîtier électrode 14 de l'électrode 5 comprend un creux de boîtier 9 destiné à recevoir la pastille à passage unidirectionnel de courant électrique 2 et l'électrode 4 dont la tête plate 11 est appliquée en contact intime de conduction électrique et thermique contre la première des deux faces opposées de la pastille 2. Le fond du creux de boîtier 9 de l'électrode 5 est pourvue d'une saillie plate circulaire 16 contre laquelle est appliquée en contact intime de conduction électrique et thermique, la deuxième des deux faces opposées de cette pastille à passage unidirectionnel de courant 2.

Le couvercle 10 qui ferme le creux de boîtier 9 de l'électrode 5 comprend deux éléments complémentaires concentriques emboîtables l'un dans l'autre, à savoir, d'une part, une coupelle centrale 17 ayant une face pleine 18 orientée vers l'extérieur, une face creuse 19 tournée vers l'intérieur du creux 9, une ouverture axiale 20 pour le passage de l'électrode 4 et un bord périphérique tronconique ou pyramidal 21 dont le périmètre grandit progressivement de la face pleine 18 vers la face creuse 19 et d'autre part un anneau extérieur, concentrique fendu 22 ayant un trou tronconique ou pyramidal 23 complémentaire et ajusté au bord périphérique tronconique ou pyramidal 21 de la coupelle centrale 17, et un bord extérieur concentrique 24 parallèle et ajusté à la paroi latérale 25 du creux de boîtier 9 de l'électrode 5.

Dans la diode 1, la pastille à passage unidirectionnel de courant 2 est fortement serrée contre la saillie plate 16 du fond du creux de boîtier 9 et la tête plate 11 de l'électrode 4, par un organe élastique 30 constitué par un ou plusieurs ressorts sous forme de rondelles ou un ressort à boudin, inséré entre la coupelle centrale 17 du couvercle 10 de ce creux de boîtier 9 et la tête plate de l'électrode 4. L'électrode 4 est électriquement isolée du couvercle 10 et de l'organe élastique 30 par un fourreau isolant 32 entourant son corps 12 et par une rondelle isolante 33 disposée entre sa tête plate 11 et une couronne de répartition de pression 34 de l'organe élastique 30. Le bord de la pastille à passage unidirectionnel de courant 2 étant espacé de la paroi latérale 25 du creux de boîtier 9, est électriquement isolé par une bande isolante 38 revêtant cette paroi dans sa partie se trouvant au-dessous du couvercle 10. Le creux de boîtier 9 est rempli d'un gaz inerte et rendu hermétique ou étanche aux fluides gazeux et liquides par une couche de résine synthétique 40 recouvrant le couvercle 10 et l'ouverture de ce creux de boîtier 9.

Dans un assemblage de la diode 1, la bande isolante 38 revêtant la paroi latérale 25 du creux de boîtier 9 de l'électrode 5 est mise en place et la pastille à passage unidirectionnel de courant 2 est montée sur le fond de ce creux de boîtier 9, centrée sur la saillie plate circulaire 16. L'électrode 4, avec la rondelle isolante 33 et la couronne de répartition de pression 34 posées sur la face interne de sa tête 11 où se trouve son corps 12, et le fourreau isolant 32 enfilé sur son corps 12 ainsi que l'organe élastique 30 et la coupelle 17 montés autour de ce fourreau isolant 32, est appliquée par la face externe de sa tête plate 11 contre la pastille à passage unidirectionnel de courant 2. Une pression préétablie de montage exercée par un dispositif d'un type connu non représenté est appliquée sur la coupelle 17 à l'encontre de l'organe élastique 30 pour mettre la coupelle 17 à une position correspondante à la position de fermeture du couvercle 10 et bander en même temps cet organe élastique 30.

L'anneau fendu 22 est inséré dans l'espace entre cette coupelle 17 et la paroi latérale 25 du creux de boîtier 9 jusqu'à son emplacement correspondant à la position de fermeture du couvercle 10.

Puis cette pression de montage est supprimée laissant agir seul l'organe élastique bandé 30. Cet organe élastique 30, par une première de ses deux extrémités, pousse axialement la coupelle 17 pour maintenir le couvercle 10 en position de fermeture en bloquant l'anneau fendu 22 et la coupelle centrale 17 dans leur emplacement par coincement engendré par une interaction du bord périphérique tronconique ou pyramidal 21 de cette coupelle centrale 17 et de la paroi du trou tronconique ou pyramidal de cet anneau fendu 22, et par une deuxième de ses deux extrémités pousse axialement la tête plate de l'électrode 4 et la pastille à passage unidirectionnel de courant 2 contre la saillie plate circulaire 16 de l'électrode 5 et maintient, de ce fait, ces électrodes 4 et 5 et la pastille 2 assemblées en contact intime de conduction électrique et thermique sous l'action permanente d'une pression.

Le creux du boîtier 9 ainsi fermé par le couvercle 10 est rempli d'un gaz inerte tel que l'azote, et rendu étanche aux fluides gazeux et liquides par une couche de résine synthétique 40 telle qu'une résine époxy.

Selon l'invention, des diodes 1 ainsi construites, permettent de réaliser d'une manière économique des ponts redresseurs d'un courant alternatif en un courant continu ou redressé, à la fois efficaces en fonctionnement, réduits en encombrement et faibles en masses.

Une variante de réalisation est illustrée dans les figures 2 et 3 où plusieurs diodes sont combinées en un sous-ensemble 50.

Selon l'invention un pont redresseur polyphasé suivant un schéma électrique connu non représenté est réalisé avec plusieurs de ces sous-ensembles 50. Un exemple d'un sous-ensemble 50 entrant dans une fabrication de pont redresseur triphasé est illustré dans les figures 2 et 3. Dans ce pont redresseur triphasé les trois diodes de chacun de ces sous-ensembles 50 ont soit leurs électrodes d'entrée de courant soit leurs électrodes de sortie de courant, reliées ensemble. Selon l'invention, le sous-ensemble à trois diodes 50 (figures 2 et 3) comprend une électrode commune 52 et trois électrodes individuelles 54, 55, 56.

Les électrodes individuelles 54, 55, 56 ont une forme analogue à celle de l'électrode 4 du premier exemple illustré dans la figure 1, autrement dit, une formée d'une vis ayant une tête plate 11, un corps lisse 12 et un bout fileté 13.

L'électrode commune 52 servant aussi de boîtier et de radiateur du sous ensemble à trois diodes 50 comprend comme l'électrode 5 dans la diode 1 du premier exemple illustré dans la figure 1 une partie massive dite boîtier-électrode 60 et une partie radiateur 61 ayant une structure massive non représentée ou taillée en ailettes (figure 2).

Dans la partie massive boîtier-électrode 60 sont formés trois creux de boîtier 62, 63, 64 munis dans leurs fonds, de trois saillies plates circulaires 67, 68, 69 contre lesquelles sont appliquées en contact intime de conduction électrique et thermique, par l'une de leurs deux faces opposées, trois pastilles à passage unidirectionnel de courant 70, 71, 72, l'autre de leurs deux faces opposées étant en contact intime de conduction électrique et thermique avec la tête plate des électrodes individuelles 54, 55, 56.

Les trois creux de boîtier 62, 63, 64 sont fermés par trois couvercles 75, 76, 77 qui ont respectivement une structure analogue à celle du couvercle 10, autrement dit des coupelles centrales 78, 79, 80 et des anneaux extérieurs fendus 81, 82, 83. Dans les trois creux de boîtier 62, 63, 64, les pastilles à passage unidirectionnel de courant 70, 71, 72 sont fortement serrées entre les saillies plates circulaires 67, 68, 69 et les têtes plates des électrodes individuelles 54, 55, 56 par des organes élastiques 86 analogues à l'organe élastique 30 du premier exemple (figure 1), constitués chacun par un ou plusieurs ressorts sous forme de rondelles ou un ressort à boudin, et insérés entre les coupelles centrales 78, 79, 80 des couvercles 75, 76, 77 de ces creux et les têtes plates de ces électrodes individuelles 54, 55, 56.

Les électrodes individuelles 54, 55, 56 sont électriquement isolées des couvercles 75, 76, 77 et des organes élastiques 86 par des fourreaux isolants et des rondelles isolantes analogues au fourreau isolant 32 et rondelle isolante 33 du premier exemple (figure 1). Des couronnes de répartition de pression sont également disposées entre les organes élastiques 86 et les rondelles isolantes des têtes plates des électrodes 54, 55, 56, et des bandes isolantes analogues à la bande isolante 38 du premier exemple (figure 1) revêtent également les parois latérales des creux du boîtier 62, 63, 64 de l'électrode commune 52 pour isoler les pastilles à passage unidirectionnel de courant 70, 71, 72 vis à vis de ces parois.

Les creux de boîtier 62, 63, 64 sont remplis d'un gaz inerte et rendus hermétiques ou étanches aux fluides gazeux et liquides par une couche de résine synthétique telle qu'une résine époxy recouvrant les couvercles 75, 76, 77.

Dans la diode 1 et dans le sous-ensemble à plusieurs diodes 50, les électrodes et les boîtiers sont ainsi assemblés d'une manière économique sans soudure ni sertissage. Etant donné que l'électrode 5 de la diode 1 et l'électrode commune 52 du sous-ensemble 50 accomplissent à la fois des fonctions d'électrode, de boîtier et de radiateur, la diode 1 et le sous-ensemble à plusieurs diodes 50 ont un encombrement et un poids réduits qui leurs permettent de faire partie des équipements légers et compacts par exemple des équipements aéronautiques.

Les électrodes sont réalisées en métal tel que l'aluminium, le bronze...

## Revendications

1. Diode à deux électrodes (5,4) maintenues assemblées respectivement aux faces opposées d'une pastille à passage unidirectionnel de courant électrique (2), par simple contact intime de conduction électrique et thermique sous l'action permanente d'une pression exercée par un organe élastique (30,86) et à boîtier, caractérisé en ce que le boîtier est assemblé sans soudure ni sertissage et en ce que le boîtier est fermé par un couvercle (10,75,76,77) maintenu solidement en position de fermeture par simple effet de coincement sous une poussée continue exercée par cet organe élastique (30,86).

2. Diode selon la revendication 1, caractérisée en ce que l'une des électrodes assemblées à la pastille (2) accomplit parallèlement trois fonctions : celle d'une électrode pour une entrée ou une sortie de courant électrique, celle d'un radiateur qui évacue la chaleur engendrée par des pertes thermiques de la diode en fonctionnement, et celle d'un boîtier de protection de cette pastille (2, 70, 71, 72) contre toutes agressions extérieures d'origine mécanique, chimique, électrique.

3. Diode selon la revendication 2, caractérisée en ce que l'électrode (5) qui sert de boîtier et de radiateur comprend une partie massive dite boîtier-électrode (14) et une partie dite radiateur (15) à structure massive ou taillée en ailettes, l'autre électrode (4) ayant une forme de vis comportant une tête plate (11), un corps lisse (12) et un bout fileté (13).

4. Diode selon la revendication 3, caractérisée en ce que la partie massive (14) comprend au moins un creux de boîtier (9) qui reçoit la pastille (2) et l'autre électrode (4), le fond du creux étant pourvu d'une saillie plate circulaire (16) contre laquelle est appliquée en contact intime de conduction électrique et thermique, l'une des deux faces opposées de la pastille (2), l'autre face de la pastille (2) étant appliquée contre la tête plate (11) de l'autre électrode (4).

5. Diode selon la revendication 4, caractérisée en ce que le creux de boîtier (9) comporte une paroi latérale (25) et en ce que le couvercle fermant le creux de boîtier comprend deux éléments complémentaires concentriques emboîtables l'un dans l'autre, à savoir d'une part une coupelle centrale (17) ayant une face pleine (18) orientée vers l'extérieur, une face creuse (19) tournée vers l'intérieur de ce creux (9, 62, 63, 64), une ouverture axiale (20) pour le passage de l'autre électrode (4, 54, 55, 56) et un bord périphérique tronconique ou pyramidal (21) dont le périmètre grandit progressivement de la face pleine (18) vers la face creuse (19) et, d'autre part, un anneau extérieur concentrique fendu (22) ayant un trou tronconique ou pyramidal (23) complémentaire et ajusté au bord périphérique tronconique ou pyramidal (21) de la coupelle centrale (17) et un bord extérieur concentrique (24), parallèle et ajusté à la paroi latérale (25) de ce creux de boîtier (9, 62, 63, 64).

6. Diode selon la revendication 5, caractérisée en ce qu'elle comprend dans le creux de boîtier (9) l'organe élastique (30) monté autour du corps de l'autre (4) électrode, qui pousse axialement, par l'une de ses extrémités la coupelle centrale (17) du couvercle (10, 75, 76, 77) pour bloquer ainsi simultanément l'anneau extérieur fendu (22) et cette coupelle centrale (17) dans leur emplacement par coincement, et par l'autre de ses extrémités, la tête plate (11) de l'autre électrode (4, 54, 55, 56) et la pastille (2, 70, 71, 72) contre la saillie plate circulaire (16, 67, 68, 69) de l'électrode (5) qui sert de boîtier et de radiateur pour maintenir ces deux électrodes et cette pastille assemblées en contact intime de conduction électrique et thermique.

7. Diode selon la revendication 6, caractérisée en ce que dans le creux de boîtier (9, 62, 63, 64), un fourreau isolant (32) est monté autour du corps (12) de l'autre électrode (4, 54, 55, 56) pour l'isoler du couvercle (10, 75, 76, 77) et de l'organe élastique (30, 86), une rondelle isolante (33) est disposée entre la tête plate de l'autre électrode (4, 55, 56) et l'organe élastique (30, 86) pour les isoler l'une de l'autre, et une bande isolante (38) revêt la paroi latérale (25) du creux de boîtier (9, 62, 63, 64) dans sa partie au-dessous du couvercle de boîtier (10, 75, 76, 77) pour isoler de cette paroi (25) le bord périphérique de la pastille (2, 70, 71, 72).

8. Pont redresseur destiné à convertir un courant alternatif en un courant continu ou redressé, caractérisé en ce qu'il comprend des diodes selon l'une des revendications 1 à 7.

9. Pont redresseur selon la revendication 8, destiné à convertir un courant alternatif polyphasé en un courant continu ou redressé, caractérisé en ce que l'électrode (52) qui sert de boîtier et de radiateur est commune pour toutes les diodes, l'autre électrode (54,55,56) de chaque diode étant individuelle.

## Patentansprüche

1. Diode mit zwei Elektroden (5, 4), die mit entgegengesetzten Flächen einer Pille (2) mit unidirektionalem Stromdurchgang durch einfachen, innigen, elektrisch und thermisch leitenden Kontakt unter der dauernden Wirkung eines von einem elastischen Organ (30, 86) ausgeübten Drucks zusammengefügtgehalten werden, und mit einem Gehäuse, dadurch gekennzeichnet, daß das Gehäuse ohne Lötung oder Schweißung und ohne Quetschverbindung zusammengebaut ist und daß das Gehäuse durch einen Deckel (10, 75, 76, 77) verschlossen ist, der durch einfache Klemmwirkung unter einer von dem elastischen Organ (30, 86) ausgeübten kontinuierlichen Schubkraft fest in der Schließstellung gehalten wird.

2. Diode nach Anspruch 1, dadurch gekennzeichnet, daß eine der mit der Pille (2) zusammengefügten Elektroden parallel drei Funktionen ausführt: diejenige einer Elektrode für einen elektrischen Stromeingang oder -ausgang, diejenige eines Kühlkörpers, der die durch thermische Verluste der Diode im Betrieb erzeugte Wärme abführt, und diejenige eines Gehäuses zum Schutz der Pille (2, 70, 71, 72) gegen alle äußeren Angriffe mechanischen, chemischen und elektrischen Ursprungs.

3. Diode nach Anspruch 2, dadurch gekennzeichnet, daß die als Gehäuse und Kühlkörper wirkende Elektrode (5) einen Gehäuse-Elektrode (14) genannten massiven Teil und einen Kühlkörper (15) genannten Teil von massiver oder mit Rippen geformter Struktur aufweist, während die andere Elektrode (4) die Form einer Schraube hat, die einen flachen Kopf (11), einen glatten Körper (12) und ein Gewindeende (13) aufweist.

4. Diode nach Anspruch 3, dadurch gekennzeichnet, daß der massive Teil (14) wenigstens einen Gehäusehohlraum (9) aufweist, der die Pille (2) und die andere Elektrode (4) aufnimmt, wobei der Boden des Hohlraums mit einem flachen kreisrunden Vorsprung (16) versehen ist, an den eine der beiden entgegengesetzten Seiten der Pille (2) in innigem, elektrisch und thermisch leitendem Kontakt angelegt ist, während die andere Seite der Pille (2) an den flachen Kopf (11) der anderen Elektrode (4) angelegt ist.

5. Diode nach Anspruch 4, dadurch gekennzeichnet, daß der Gehäusehohlraum (9) eine Seitenwand (25) aufweist und daß der den Gehäusehohlraum verschließende Deckel zwei ineinandersteckbare konzentrische, zueinander komplementäre Elemente aufweist, nämlich einerseits eine zentrale Schale (17) mit einer nach außen gerichteten vollen Seite (18), einer zum Inneren des Hohlraums (9, 62, 63, 64) gerichteten ausgehöhlten Seite (19), einer axialen Öffnung (20) für den Durchgang der anderen Elektrode (4, 54, 55, 56) und einen kegelstumpfförmigen oder pyramidenförmigen Rand (21), dessen Umfang von der vollen Seite (18) zu der ausgehöhlten Seite (19) fortschreitend zunimmt, und andererseits einen geschlitzten konzentrischen äußeren Ring (22), der ein kegelstumpfförmiges oder pyramidenförmiges Loch (23) hat, das zu dem kegelstumpfförmigen oder pyramidenförmigen Rand (21) der zentralen Schale (17) komplementär und an diese angepaßt ist, sowie einen konzentrischen Außenrand (24), der zu der Seitenwand (25) des Gehäusehohlraums (9, 62, 63, 64) parallel und an diese angepaßt ist.

6. Diode nach Anspruch 5, dadurch gekennzeichnet, daß sie in dem Gehäusehohlraum (9) das rings um den Körper der anderen Elektrode (4) montierte elastische Organ (30) enthält, das mit dem einen seiner Enden die zentrale Schale (17) des Deckels (10, 75, 76, 77) axial drückt, um dadurch gleichzeitig den geschlitzten äußeren Ring (22) und die zentrale Schale (17) durch Verklemmen an ihrer Stelle zu blockieren, und mit dem anderen seiner Enden den flachen Kopf (11) der anderen Elektrode (4, 54, 55, 56) und die Pille (2, 70, 71, 72) gegen den kreisrunden flachen Vorsprung (16, 67, 68, 69) der Elektrode (5), die als Gehäuse und Kühlkörper wirkt, um diese beiden Elektroden und diese Pille in innigem, elektrisch und thermisch leitendem Kontakt zusammengefügt zu halten.

7. Diode nach Anspruch 6, dadurch gekennzeichnet, daß in dem Gehäusehohlraum (9, 62, 63, 64) eine Isolierhülse (32) rings um den Körper (12) der anderen Elektrode (4, 54, 55, 56) angebracht ist, um ihn von dem Deckel (10, 75, 76, 77) und dem elastischen Organ (30, 86) zu isolieren, daß eine Isolierscheibe (33) zwischen dem flachen Kopf der anderen Elektrode (4, 55, 56) und dem elastischen Organ (30, 86) angeordnet ist, um diese Teile voneinander zu isolieren, und daß ein Isolierband (38) die Seitenwand (25) des Gehäusehohlraums (9, 62, 63, 64) in dessen unterhalb des Gehäusedeckels (10, 75, 76, 77) liegendem Teil bedeckt, um diese Wand von dem Umfangsrand der Pille (2, 70, 71, 72) zu isolieren.

8. Gleichrichterbrücke zur Umwandlung eines Wechselstroms in einen Gleichstrom oder gleichgerichteten Strom, dadurch gekennzeichnet, daß sie Dioden nach einem der Ansprüche 1 bis 7 enthält.

9. Gleichrichterbrücke nach Anspruch 8 zur Umwandlung eines Mehrphasen-Wechselstroms in einen Gleichstrom oder gleichgerichteten Strom, dadurch gekennzeichnet, daß die Elektrode (52), die als Gehäuse und Kühlkörper dient, allen Dioden gemeinsam ist, während die andere Elektrode (54, 55, 56) jeder Diode individuell ist.

## Claims

1. Diode having two electrodes (5, 4) held assembled together respectively against the opposite faces of a chip allowing unidirectional passage of an electric current (2), by simple intimate contact providing electrical and thermal conduction under the permanent action of a pressure exerted by an elastic element (30, 86), and having a housing, characterized in that the housing is assembled without any soldering or crimping and in that the housing is closed by a lid (10, 75, 76, 77) firmly held in the closure position by a simple wedging effect under a continuous thrust exerted by this elastic element (30, 86).

2. Diode according to Claim 1, characterized in that one of the electrodes assembled with the chip (2) performs three functions at the same time: that of an electrode for an input or an output of electric current, that of a heat sink which carries away the heat generated by heat losses from the diode during operation, and that of a housing for protecting this chip (2, 70, 71, 72) from any external attack of mechanical, chemical or electrical origin.

3. Diode according to Claim 2, characterized in that the electrode (5) which serves as housing and heat sink comprises a so-called housing-electrode solid part (14) and a so-called heat-sink part (15) having a solid structure or a structure cut into fins, the other electrode (4) being in the form of a bolt having a flat head (11), a smooth body (12) and a threaded end (13).

4. Diode according to Claim 3, characterized in that the solid part (14) comprises at least one housing recess (9) which accommodates the chip (2) and the other electrode (4), the bottom of the recess being provided with a circular flat projection (16) against which is applied, in intimate contact providing electrical and thermal conduction, one of the two opposite faces of the chip (2), the other face of the chip (2) being applied against the flat head (11) of the other electrode (4).

5. Diode according to Claim 4, characterized in that the housing recess (9) includes a side wall (25) and in that the lid closing the housing recess comprises two concentric complementary elements which can be fitted one into the other, namely, on the one hand, a central cup (17) having a solid face (18) oriented towards the outside, a recessed face (19) turned towards the inside of this recess (9, 62, 63, 64), an axial opening (20) through which the other electrode (4, 54, 55, 56) passes, and a frustoconical or pyramidal peripheral edge (21) whose perimeter gradually increases from the solid face (18) to the recessed face (19) and, on the other hand, a split concentric external ring (22) having a complementary frustoconical or pyramidal hole (23) and fitted against the frustoconical or pyramidal peripheral edge (21) of the central cup (17) and a concentric external edge (24) which is parallel to and fitted against the side wall (25) of this housing recess (9, 62, 63, 64).

6. Diode according to Claim 5, characterized in that, in the housing recess (9), it comprises the elastic element (30) mounted around the body of the other electrode (4), which axially pushes, via one of its ends, the central cup (17) of the lid (10, 75, 76, 77), in order thereby to lock the split external ring (22) and its central cup (17) in their wedging position simultaneously, and, via the other of its ends, the flat head (11) of the other electrode (4, 54, 55, 56) and the chip (2, 70, 71, 72) against the circular flat projection (16, 67, 68, 69) of the electrode (5) which serves as the housing and heat sink, in order to hold these two electrodes and this chip assembled together in intimate contact providing electrical and thermal conduction.

7. Diode according to Claim 6, characterized in that, in the housing recess (9, 62, 63, 64), an insulating sheath (32) is mounted around the body (12) of the other electrode (4, 54, 55, 56) in order to insulate it from the lid (10, 75, 76, 77) and from the elastic element (30, 86), an insulating washer (33) is placed between the flat head of the other electrode (4, 55, 56) and the elastic element (30, 86) in order to insulate them from each other, and an insulating strip (38) lines the side wall (25) of the housing recess (9, 62, 63, 64) in its part below the housing lid (10, 75, 76, 77) in order to insulate the peripheral edge of the chip (2, 70, 71, 72) from this wall (25).

8. Rectifier bridge intended to convert an alternating current into a direct or rectified current, characterized in that it comprises diodes according to one of Claims 1 to 7.

9. Rectifier bridge according to Claim 8, intended to convert a polyphase alternating current into a direct or rectified current, characterized in that the electrode (52) which serves as the housing and heat sink is common for all the diodes, the other electrode (54, 55, 56) of each diode being an individual electrode.
